(19)

**Europäisches Patentamt**
**European Patent Office**
**Office européen des brevets**

(11) **EP 4 672 317 A1**

(12) **EUROPEAN PATENT APPLICATION**

(43) Date of publication:
**31.12.2025 Bulletin 2026/01**

(51) International Patent Classification (IPC):
**H01L 23/15** *(2006.01)*      **H01L 23/498** *(2006.01)*

(21) Application number: **25165846.4**

(22) Date of filing: **25.03.2025**

(52) Cooperative Patent Classification (CPC):
**H01L 23/49894; H01L 23/15**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.06.2024 US 202463666118 P**

(71) Applicant: **Absolics Inc.**
**Covington, GA 30014 (US)**

(72) Inventors:
- **KIM, Jincheol**
  **18469 Hwaseong-si, Gyeonggi-do (KR)**
- **Yun, SeHan**
  **Covington, Georgia, 30014 (US)**
- **JO, Jungju**
  **Covington, Georgia, 30014 (US)**
- **KIM, Tae Kyoung**
  **Covington, Georgia, 30014 (US)**
- **OH, Jun Rok**
  **18469 Hwaseong-si, Gyeonggi-do (KR)**

(74) Representative: **BCKIP Part mbB**
**Landsberger Straße 98**
**80339 München (DE)**

(54) **PACKAGING SUBSTRATE AND SEMICONDUCTOR PACKAGE COMPRISING THE SAME**

(57)      A packaging substrate according to the present disclosure includes a glass core and an insulating layer disposed on the glass core. The glass core has a thickness of 100 $\mu$m or more. The insulating layer has an HEI value, which is the heat-resistant elasticity index of Equation 1 below, of 1.2 or more.

[Equation 1]

$$HEI = \frac{Tg}{E \times CTE}$$

in Equation 1,
Tg is the glass transition temperature (unit: °C), E is the elastic modulus (unit: GPa) measured at 23°C, and CTE is the coefficient of thermal expansion (ppm/°C).
In this case, damage to the glass core during a process of forming a redistribution layer can be effectively suppressed.

EP 4 672 317 A1

## Description

This application claims the priority benefit of U.S. provisional patent application No. 63/666,118 filed on June 29, 2024, in U.S. Patent and Trademark Office.

## BACKGROUND

### Technical Field

The present disclosure relates to a packaging substrate and a semiconductor package including the same.

### Description of Related Art

In manufacturing electronic parts, forming a circuit on a semiconductor wafer is called the front-end (FE) process, and assembling the wafer into a state where it may be used in an actual product is called the back-end (BE) process. The packaging process is included in the back-end process.

The four core technologies of the semiconductor industry that have enabled recent rapid development of electronic products are semiconductor technology, semiconductor packaging technology, manufacturing process technology, and software technology. Semiconductor technology is developing in various forms, such as sub-micron nano-scale line widths, at least 10 million cells, high-speed operation, large heat dissipation, etc., but technology to perfectly package the semiconductor is relatively lacking. Accordingly, electrical performance of a semiconductor is often determined by the packaging technology and the resulting electrical connection rather than performance of the semiconductor technology itself.

Ceramic or resin is used as the material for the packaging substrate. Ceramic substrates have high resistance or dielectric constant, making it difficult to mount high-performance high-frequency semiconductor elements thereon. Resin substrates enable mounting of high-performance high-frequency semiconductor elements, but there are limits to reducing the pitch of the wiring.

Recently, research is ongoing into applying silicon or glass to high-end packaging substrates. By forming a through hole in a silicon or glass substrate and applying a conductive material to the through hole, the wiring length between an element and a motherboard may be shortened and excellent electrical characteristics may be achieved.

## SUMMARY

An embodiment of the present disclosure provides a packaging substrate including a glass core and an insulating layer disposed on the glass core.

The glass core may have a thickness of 100 $\mu$m or more.

The insulating layer may have an HEI value, which is a heat-resistant elasticity index of Equation 1 below, of 1.2 or more:

[Equation 1]

$$HEI = \frac{Tg}{E \times CTE}$$

in Equation 1, Tg is the glass transition temperature (unit: °C), E is the elastic modulus (unit: GPa) measured at 23°C, and CTE is the coefficient of thermal expansion (ppm/°C).

The insulating layer may have an HMI value, which is a heat-resistant mechanical property index of Equation 2 below, of 1.4 or more:

[Equation 2]

$$HMI = \frac{10 \times Tg \times Eln}{(10E + T) \times CTE}$$

in Equation 2, Tg is the glass transition temperature (unit: °C), CTE is the coefficient of thermal expansion (ppm/°C), E is the elastic modulus (unit: GPa) of the insulating layer measured at 23°C, T is the tensile strength (unit: MPa) of the insulating layer measured at 23°C, and Eln is the elongation (%) of the insulating layer measured at 23°C.

The elastic modulus of the insulating layer measured at 23°C may be 8 GPa or less.

The coefficient of thermal expansion of the insulating layer may be 25 ppm/°C or less.

The glass transition temperature of the insulating layer may be 160°C or more.

The tensile strength of the insulating layer measured at 23°C may be 80 MPa or less.

The packaging substrate may include a first redistribution layer disposed on the glass core.

The first redistribution layer may include an electrically conductive layer and the insulating layer surrounding at least a portion of the electrically conductive layer.

A ratio of the thickness of the first redistribution layer relative to the thickness of the glass core may be 0.3 or more.

The packaging substrate may further include a second redistribution layer disposed under the glass core.

The second redistribution layer may include the electrically conductive layer and the insulating layer surrounding at least a portion of the electrically conductive layer.

A ratio of a sum of the thickness of the first redistribution layer and the thickness of the second redistribution layer relative to the thickness of the glass core may be 0.5 or more.

The insulating layer may include a curable resin and a filler.

The insulating layer may include at least 65 wt% of the filler.

The packaging substrate may include a first electrically conductive layer disposed in contact with the upper surface of the glass core.

The insulating layer may surround a portion of the first electrically conductive layer.

A ratio of an area occupied by the first electrically conductive layer on the upper surface of the glass core relative to a total area of the upper surface of the glass core may be 80% or less.

## BRIEF DESCRIPTION OF THE DRAWINGS

FIG. 1 is a conceptual diagram explaining the SeWaRe phenomenon.

FIG. 2 is a cross-sectional view showing a packaging substrate according to an embodiment of the present disclosure.

FIG. 3 is a cross-sectional view showing a packaging substrate according to another embodiment of the present disclosure.

## DESCRIPTION OF THE EMBODIMENTS

Hereinafter, embodiments of the present disclosure will be described in detail with reference to the appended drawings so that they may be easily implemented by those with ordinary skill in the art to which the present disclosure pertains. However, the present invention may be embodied in a variety of different forms and is not limited to the embodiments described herein. Like reference numerals have been assigned to like parts throughout the specification.

Herein, the term "combination thereof" included in the expressions in the Markush format refers to a mixture or combination of one or more selected from the group consisting of components described in the expressions in the Markush format, and means including one or more selected from the group consisting of the components.

Herein, terms such as "first" and "second", or "A" and "B" are used to distinguish the same terms from each other unless otherwise specified. Also, singular expressions include plural expressions unless the context clearly indicates otherwise.

The term "-based compound" may mean that the compound includes a compound corresponding to "-" or a derivative of "-".

Herein, B being located on A means that B is located in direct contact with A or that B is located on A with a further layer interposed therebetween, and is not interpreted as being limited to B being located in contact with the surface of A.

Herein, B being connected to A means that A and B are directly connected or connected through a further component between A and B, and unless specified otherwise, it is not interpreted as being limited to A and B being directly connected.

Herein, singular expressions are interpreted to include the singular or plural as interpreted by the context, unless specified otherwise.

Herein, the shape, relative size, angle, etc. of each component in the drawings may be exaggerated for explanatory purposes, and the rights are not interpreted as limited to the drawings.

Herein, A and B being adjacent means that A and B are located in contact with each other, or A and B are not in contact but are located close to each other. Herein, the expression that A and B are adjacent is not interpreted as being limited to A and B being located in contact unless specifically stated otherwise.

Herein, a fine line means a line having a width of 5 μm or less, unless specified otherwise, and by way of example, a line having a width of 1 to 4 μm.

Unless specified otherwise herein, the property values of each component within the packaging substrate are interpreted as measured at room temperature. Room temperature is 20°C to 25°C.

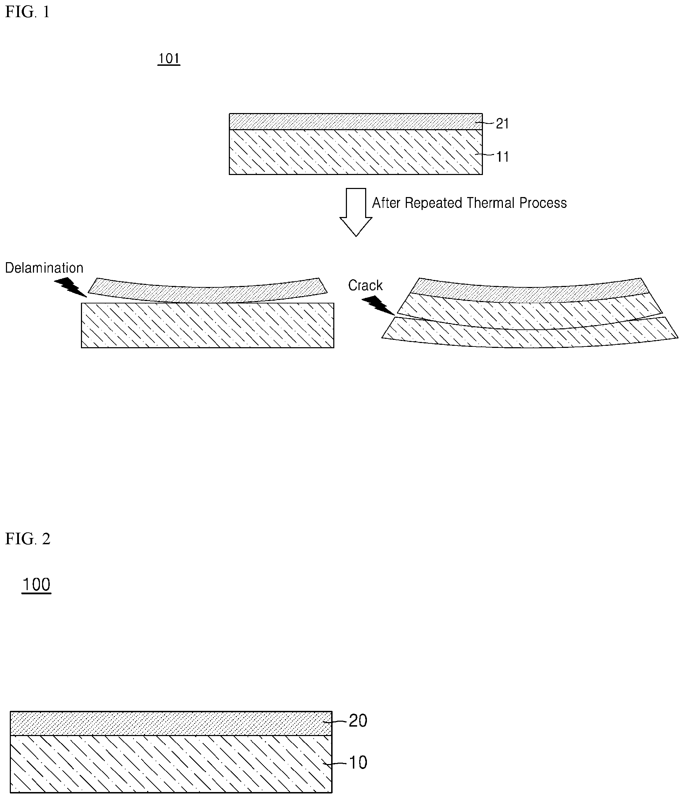

FIG. 1 is a conceptual diagram explaining the SeWaRe phenomenon. Below, a problem to be solved of the present disclosure is described with reference to FIG. 1.

An insulating layer may be formed by curing a film or composition for forming an insulating layer 21 disposed on a glass substrate 11 in a high-temperature atmosphere. The process of disposing and curing a film on a glass substrate may be performed repeatedly to form a multilayered insulating layer on the glass substrate. As such, a significant tensile stress may be applied to the glass substrate due to thermal expansion and contraction of the insulating layer, and this stress may cause the insulating layer to peel off or may cause the glass substrate to split in the in-plane direction, a phenomenon called SeWaRe during the insulating layer formation process or the substrate dicing process.

The inventors of the present disclosure have experimentally ascertained that damage to the glass core may be effectively suppressed through means such as controlling the thickness of the glass core included in the packaging substrate and the heat-resistant elasticity index of the insulating layer, thus culminating in the present disclosure.

Below is a detailed description of the present disclosure.

FIG. 2 is a cross-sectional view showing a packaging substrate according to an embodiment of the present disclosure. Below, the present disclosure is described with reference to FIG. 2.

Glass core

A packaging substrate 100 according to the present disclosure may include a glass core 10.

The glass core 10 may have the shape of a glass substrate. The glass core 10 may include, for example, alkali borosilicate plate glass, alkali-free borosilicate plate glass, alkali-free alkaline earth borosilicate plate glass, etc., and any plate glass for use in an electronic part may be employed. The glass core 10 may include a glass substrate for electronic devices, and examples thereof include those manufactured by Schott, AGC, Corning, etc., but are not limited thereto.

The glass core 10 may include a through via (not shown) penetrating in the thickness direction of the glass core 10.

A through via is composed of an inner space (not shown) and a via inner surface (not shown) surrounding the inner space. The inner space means an empty space, and the via inner surface means the surface of the glass core 10 formed inside the through via.

The through via may have a diameter that varies in the thickness direction of the glass core 10. The through via may have a substantially uniform diameter in the thickness direction of the glass core 10.

The surface of the glass core 10 may include an upper surface and a side surface formed in the thickness direction of the glass core 10 and connected to the upper surface. The surface of the glass core 10 may include a lower surface facing the upper surface.

The fact that the side surface is formed in the thickness direction of the glass core 10 is interpreted to mean that the side surface is not only formed perpendicular to the upper surface of the glass core 10, but also at least a portion of the side surface is formed at an angle (inclination angle) other than 90 degrees with the upper surface.

The side surface may be flat or curved.

The glass core 10 may include a cavity (not shown), which is a space formed by the interior being recessed.

The cavity may be formed by a portion of the upper/lower surface of the glass core 10 being recessed in the thickness direction of the glass core 10, or may be formed by penetrating through the thickness direction of the glass core 10.

An element may be mounted in the cavity so that the packaging substrate 100 and the element may be electrically connected. Elements may include not only semiconductor elements such as CPUs, GPUs, memory chips, etc., but also capacitor elements, transistor elements, impedance elements, and other modules. Briefly, any semiconductor element mounted on a semiconductor device may be used without limitation.

Properties of insulating layer

The packaging substrate 100 may include an insulating layer 20 disposed on the glass core 10. At least a portion of the insulating layer 20 may be disposed in contact with the upper surface of the glass core 10.

In the present disclosure, the HEI value, which is a heat-resistant elasticity index of Equation 1 below, which is a property related to heat resistance and elasticity of the insulating layer 20, and the thickness of the glass core 10 may be controlled together.

[Equation 1]

$$HEI = \frac{Tg}{E \times CTE}$$

In Equation 1, Tg is the glass transition temperature (unit: °C), E is the elastic modulus (unit: GPa) measured at 23°C, and CTE is the coefficient of thermal expansion (ppm/°C).

The HEI value is a parameter that reflects the mechanical properties of the insulating layer 20 that may affect heat resistance of the insulating layer 20 and thermal stress of the glass core 10. When the heat-resistant elasticity index of the insulating layer 20 is adjusted within a range preset in the present disclosure, even if the packaging substrate is repeatedly exposed to a high-temperature atmosphere, thermal stress equal to or less than a certain level may be applied to the glass core 10, and deterioration of the insulating layer 20 at a high temperature may be suppressed.

In addition, when the thickness of the glass core 10 is controlled, tensile stress may be prevented from being excessively concentrated in a specific portion within the glass core 10.

The glass transition temperature and the coefficient of thermal expansion of the insulating layer 20 are measured using a thermomechanical analyzer (TMA) according to the JIS-C6481 standard. As such, the tensile method is performed according to the IPC-TM650, and the heating rate is set to 10°C/min. The coefficient of thermal expansion is measured within the range of 25°C to 100°C.

The elastic modulus of the insulating layer 20 is measured in pull mode at 23°C using a universal testing machine (UTM). As such, measurement was performed at a tensile speed of 1 mm/min under N=5 average conditions.

The HEI value of the insulating layer 20 may be 1.2 or more. The HEI value thereof may be 1.3 or more. The HEI value thereof may be 1.4 or more. The HEI value thereof may be 1.5 or more. The HEI value thereof may be 3 or less.

The thickness of the glass core 10 may be 100 μm or more. The thickness thereof may be 200 μm or more. The thickness thereof may be 300 μm or more. The thickness thereof may be 3,000 μm or less. The thickness thereof may be 2,000 μm or less. The thickness thereof may be 1,000 μm or less.

As such, stress applied to the glass core 10 depending on a change in atmosphere temperature may be effectively reduced, and thermal deformation of the insulating layer 20 may be suppressed.

The HMI value, which is the heat-resistant mechanical property index of Equation 2 below of the insulating layer 20, may be 1.4 or more.

[Equation 2]

$$HMI = \frac{10 \times Tg \times Eln}{(10E + T) \times CTE}$$

In Equation 2, Tg is the glass transition temperature (unit: °C), CTE is the coefficient of thermal expansion (ppm/°C), E is the elastic modulus (unit: GPa) of the insulating layer 20 measured at 23°C, T is the tensile strength (unit: MPa) of the insulating layer 20 measured at 23°C, and Eln is the elongation (%) of the insulating layer 20 measured at 23°C.

The HMI value is a parameter that reflects heat resistance and flexibility of the insulating layer 20. By controlling the HMI value of the insulating layer 20 within a range preset in the present disclosure, tensile stress acting on the glass core 10 due to curing, thermal expansion, and thermal contraction of the insulating layer 20 may be stably reduced. In addition, the cured insulating layer 20 may remain cured stably even when repeatedly exposed to a high-temperature environment.

The elongation of the insulating layer 20 is measured in pull mode at 23°C using a universal testing machine (UTM). As such, measurement was performed at a tensile speed of 1 mm/min under N=5 average conditions. The HMI value of the insulating layer 20 may be 1.4 or more. The HMI value of the insulating layer 20 may be 1.5 or more. The HMI value of the insulating layer 20 may be 1.6 or more. The HMI value of the insulating layer 20 may be 3 or less. As such, occurrence of the SeWaRe phenomenon in the glass core 10 during the process of forming the multilayered insulating layer 20 may be suppressed.

The elastic modulus of the insulating layer 20 measured at 23°C may be 8 GPa or less. The elastic modulus thereof may be 7.5 GPa or less. The elastic modulus thereof may be 7 GPa or less. The elastic modulus thereof may be 4 GPa or more. As such, even when the insulating layer 20 is cured or thermally contracted, the stress acting on the glass core 10 may be reduced to a certain level or less.

The coefficient of thermal expansion of the insulating layer 20 may be 25 ppm/°C or less. The coefficient of thermal expansion thereof may be 22 ppm/°C or less. The coefficient of thermal expansion thereof may be 18 ppm/°C or less. The coefficient of thermal expansion thereof may be 5 ppm/°C or more. As such, peeling of the insulating layer and

EP 4 672 317 A1

damage to the glass core may be suppressed by controlling the difference in thermal expansion and thermal contraction characteristics between the insulating layer 20 and the glass core 10.

The glass transition temperature of the insulating layer 20 may be 160°C or more. The glass transition temperature thereof may be 163°C or more. The glass transition temperature thereof may be 165°C or more. The glass transition temperature thereof may be 167°C or more. The glass transition temperature thereof may be 170°C or more. The glass transition temperature thereof may be 200°C or less. As such, in the process of disposing and curing a film for forming an insulating layer 20 on the cured insulating layer 20, the already cured insulating layer 20 may be prevented from becoming rubberized and damaging the electrical connection.

The tensile strength of the insulating layer 20 measured at 23°C may be 80 MPa or less. The tensile strength thereof may be 75 MPa or less. The tensile strength thereof may be 70 MPa or less. The tensile strength thereof may be 67 MPa or less. The tensile strength thereof may be 40 MPa or more. As such, the insulating layer 20 may have flexibility suitable for application on the glass core 10.

The dielectric constant of the insulating layer 20 at a frequency of 10 GHz may be 6 or less. The dielectric constant thereof may be 5 or less. The dielectric constant thereof may be 4 or less. The dielectric constant thereof may be 0.5 or more.

The loss tangent of the insulating layer 20 at a frequency of 10 GHz may be 0.03 or less. The loss tangent thereof may be 0.025 or less. The loss tangent thereof may be 0.02 or less. The loss tangent thereof may be 0.005 or more.

As such, a redistribution layer including the insulating layer 20 may serve to efficiently transmit signals.

The dielectric constant and loss tangent of the insulating layer 20 are measured at room temperature using a dielectric constant meter.

In the present disclosure, the boiling water absorption rate of the insulating layer 20 may be controlled within a specific range. Thereby, it is possible to stably maintain insulation reliability between electrically conductive layers in the redistribution layer by imparting controlled hydrophilicity to the insulating layer 20.

The boiling water absorption rate of the insulating layer 20 is measured by the following method. The insulating layer 20 is cut to 30 mm in width, 30 mm in length, and 50 $\mu$m in thickness to prepare a test specimen. After drying the test specimen at 130°C for 30 minutes, the mass thereof is measured. Thereafter, the test specimen is immersed in boiled deionized water for 1 hour, then taken out, and then immersed in deionized water at room temperature for 1 minute, then taken out. Thereafter, the moisture on the surface of the test specimen is removed and then the mass of the test specimen is measured. The change in mass of the test specimen before and after immersion compared to the mass of the test specimen before immersion is calculated as the boiling water absorption rate.

The boiling water absorption rate per 1 hour of the insulating layer 20 may be 2 wt% or less. The boiling water absorption rate thereof may be 1.5 wt% or less. The boiling water absorption rate thereof may be 1 wt% or less. The boiling water absorption rate thereof may be 0.1 wt% or more. As such, it is possible to impart excellent electrical reliability to the packaging substrate 100.

Composition of insulating layer

The insulating layer 20 may include an epoxy resin and a filler. The insulating layer 20 may include a cured epoxy resin and a filler.

The epoxy resin may be any one selected from the group consisting of bisphenol-type epoxy resin, novolac-type epoxy resin, biphenyl-type epoxy resin, arylalkylene-type epoxy resin, tetraphenylolethane-type epoxy resin, naphthalene-type epoxy resin, anthracene-type epoxy resin, phenoxy-type epoxy resin, dicyclopentadiene-type epoxy resin, norbornene-type epoxy resin, and combinations thereof.

The insulating layer 20 may include 10 wt% or more of the epoxy resin. The insulating layer 20 may include 15 wt% or more of the epoxy resin. The insulating layer 20 may include 20 wt% or more of the epoxy resin. The insulating layer 20 may include 35 wt% or less of the epoxy resin. The insulating layer 20 may include 32 wt% or less of the epoxy resin. The insulating layer 20 may include 29 wt% or less of the epoxy resin. The insulating layer 20 may include 25 wt% or less of the epoxy resin.

The insulating layer 20 may include a filler. The filler may include an inorganic filler. The inorganic filler may be any one selected from the group consisting of barium sulfate, silica, talc, clay, magnesium carbonate, calcium carbonate, aluminum oxide, aluminum hydroxide, silicon nitride, aluminum nitride, titanium oxide, and combinations thereof.

The average diameter of the inorganic filler may be 5 $\mu$m or less. The average diameter thereof may be 4 $\mu$m or less. The average diameter thereof may be 3 $\mu$m or less. The average diameter thereof may be 2 $\mu$m or less. The average diameter thereof may be 0.5 $\mu$m or more.

The maximum diameter of the inorganic filler may be 20 $\mu$m or less. The maximum diameter thereof may be 17 $\mu$m or less. The maximum diameter thereof may be 15 $\mu$m or less. The maximum diameter thereof may be 12 $\mu$m or less. The maximum diameter thereof may be 10 $\mu$m or less. The maximum diameter thereof may be 5 $\mu$m or more.

As such, it is possible to stably obtain electrical reliability of the packaging substrate 100 by allowing a fine redistribution layer to be precisely formed on the insulating layer 20.

The filler may further include an organic filler. The organic filler within the insulating layer 20 may exhibit attraction properties through interaction. Such properties may help reduce the extent of thermal expansion of the insulating layer 20 with an increase in temperature.

The organic filler may have a fine fiber shape with a diameter of 100 nm or less. The organic filler may include a fine cellulose powder. The organic filler may be a fine cellulose powder. A fine cellulose powder may be obtained from a natural plant fiber raw material such as wood, flax, bamboo, cotton, etc. Specifically, a fine cellulose powder may be obtained by subjecting a natural plant fiber raw material to pulverization treatment, high-temperature and high-pressure steam treatment, acid treatment, oxidation treatment, etc.

The insulating layer 20 may include 65 wt% or more of the filler. The insulating layer 20 may include 68 wt% or more of the filler. The insulating layer 20 may include 71 wt% or more of the filler. The insulating layer 20 may include 75 wt% or more of the filler. The insulating layer 20 may include 90 wt% or less of the filler. As such, it is possible to impart a relatively low coefficient of thermal expansion and high flexibility to the insulating layer 20.

The filler may include 1 wt% to 25 wt% of the organic filler. The filler may include 5 wt% or more of the organic filler. The filler may include 10 wt% or more of the organic filler. The filler may include 20 wt% or less of the organic filler. As such, it is possible to control thermal expansion characteristics of the insulating layer 20 more stably.

The insulating layer 20 may further include an additive other than the components described above. Any additive commonly used in the field of packaging substrates may be used without limitation. Examples of the additive include a stiffener, a colorant, an antifoaming agent, and the like.

Electrically conductive layer

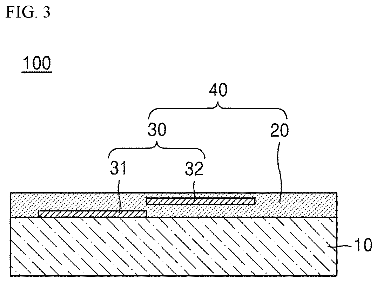

FIG. 3 is a cross-sectional view showing a packaging substrate according to another embodiment of the present disclosure. Below, the present disclosure is described with reference to FIG. 3.

The packaging substrate 100 includes a glass core 10 and an insulating layer 20 disposed on the glass core 10. Components of the packaging substrate 100 are the same as in FIG. 1 except for differences as described below.

The packaging substrate 100 may include a first redistribution layer 40 disposed on the glass core 10. The first redistribution layer 40 may include an electrically conductive layer 30 and an insulating layer 20 surrounding at least a portion of the electrically conductive layer 30.

The electrically conductive layer 30 is a conductor configured to transmit electrical signals. The electrically conductive layer 30 may include an electrically conductive material. For example, the electrically conductive layer 30 may include at least one of copper, nickel, aluminum, gold, or silver. Copper, etc. may be used as a material for the electrically conductive layer 30.

A description of the properties and composition of the insulating layer 20 is omitted as it overlaps with that described above.

The first redistribution layer 40 may be disposed in contact with the upper surface of the glass core 10. Other components may be interposed between the first redistribution layer 40 and the upper surface of the glass core 10.

In the first redistribution layer 40, the insulating layer 20 and the electrically conductive layer 30 may be disposed in combination. The first redistribution layer 40 may be provided in a form in which an electrically conductive layer 30 having a predetermined position and shape is embedded in an insulating layer 20. The electrically conductive layer 30 may be provided in the form of a fine line in at least a portion of the first redistribution layer 40. The first redistribution layer 40 may be electrically connected to terminals and elements located on the packaging substrate 100.

The electrically conductive layer 30 may include a first electrically conductive layer 31 disposed in contact with the upper surface of the glass core 10. The insulating layer 20 may surround a portion of the first electrically conductive layer 31. The insulating layer 20 may surround at least a portion of the upper surface of the first electrically conductive layer 31. The insulating layer 20 may surround at least a portion of the side surface of the first electrically conductive layer 31.

The electrically conductive layer 30 may include a second electrically conductive layer 32 that is disposed above the glass core 10 without contacting the upper surface of the glass core 10. The insulating layer 20 may surround at least a portion of the second electrically conductive layer 32. The insulating layer 20 may surround the entire second electrically conductive layer 32.

The ratio of the area occupied by the first electrically conductive layer 31 on the upper surface of the glass core 10 relative to the total area of the upper surface of the glass core 10 may be 80% or less.

In the process of forming the insulating layer 20, the glass core 10 and the first electrically conductive layer 31 may also be repeatedly exposed to a high-temperature atmosphere. The glass core 10 and the first electrically conductive layer 31 may exhibit different thermal expansion characteristics. This difference in characteristics may cause cracks in the glass core 10 having high hardness during the process in which the glass core 10 and the first electrically conductive layer 31 thermally expand and contract.

In the present disclosure, it is possible to stably regulate the stress of the glass core 10 caused by thermal expansion and contraction of the first electrically conductive layer 31 by controlling the area occupied by the first electrically conductive layer 31 on the entire upper surface of the glass core 10.

The ratio of the area occupied by the first electrically conductive layer 31 on the upper surface of the glass core 10 relative to the total area of the upper surface of the glass core 10 may be 80% or less. The ratio thereof may be 75% or less. The ratio thereof may be 70% or less. The ratio thereof may be 30% or more. As such, the frequency of cracks occurring in the glass core 10 may be effectively reduced.

The electrically conductive layer 30 may be disposed on the insulating layer 20. The electrically conductive layer 30 may be disposed in contact with the upper surface of the insulating layer 20.

The peel strength of the electrically conductive layer 30 to the upper surface of the insulating layer 20 may be 3 N/cm or more. The peel strength thereof is 3.5 N/cm or more. The peel strength thereof may be 4 N/cm or more. The peel strength thereof may be 10 N/cm or less. As such, the insulating layer 20 may serve to stably support, protect, and insulate the electrically conductive layer 30.

The peel strength of the electrically conductive layer 30 to the insulating layer 20 is measured using a bond tester according to a 180° peel test. The measurement speed (peeling speed) is set to 10 mm/s, the measurement distance (peeling distance) is set to 70 mm, and the measurement area is set to the area on the upper/lower surface of the glass core 10 where no through-via is formed. For example, the peel strength values may be measured using a Condor Sigma bond tester from XYZ TEC.

The ratio of the thickness of the first redistribution layer 40 relative to the thickness of the glass core 10 may be 0.3 or more.

As the first redistribution layer 40 has more layers and thus has a greater thickness, the stress applied to the glass core 10 due to the formation of the first redistribution layer 40 may increase. The packaging substrate 100 of the present disclosure includes the insulating layer 20 in which heat resistance characteristics and mechanical properties are controlled within ranges preset in the present disclosure, thereby making it possible to suppress damage to the glass core 10 and provide a more highly integrated packaging substrate 100.

The ratio of the thickness of the first redistribution layer 40 relative to the thickness of the glass core 10 may be 0.3 or more. The thickness ratio thereof may be 0.4 or more. The thickness ratio thereof may be 0.5 or more. The thickness ratio thereof may be 0.6 or more. The thickness ratio thereof may be 1 or less. As such, a packaging substrate 100 having a high degree of integration of a multilayer structure may be provided.

The packaging substrate 100 may further include a second redistribution layer (not shown) disposed under the glass core 10.

The second redistribution layer may include an electrically conductive layer and an insulating layer surrounding at least a portion of the electrically conductive layer. A description of the electrically conductive layer and the insulating layer is omitted as it overlaps with that described above.

In the second redistribution layer, the insulating layer and the electrically conductive layer may be disposed in combination. The second redistribution layer may be provided in a form in which an electrically conductive layer having a predetermined position and shape is embedded within the insulating layer. The second redistribution layer may be electrically connected to terminals and main boards located under the packaging substrate 100.

The ratio of a sum of the thickness of the first redistribution layer and the thickness of the second redistribution layer relative to the thickness of the glass core 10 may be 0.5 or more. The thickness ratio thereof may be 0.6 or more. The thickness ratio thereof may be 0.7 or more. The thickness ratio thereof may be 0.8 or more. The thickness ratio thereof may be 1 or more. The thickness ratio thereof may be 3 or less. As such, a pattern with a high degree of integration may be formed on and under the glass core 10.

The packaging substrate 100 may further include a bump (not shown) disposed under the second redistribution layer.

The bump may be disposed in a predetermined form under the glass core 10. For example, the bump may be disposed on a portion of the lower surface of the packaging substrate 100 so as to come into contact with a main board, etc.

Semiconductor package

A semiconductor package according to still another embodiment of the present disclosure includes a packaging substrate and an element electrically connected to the packaging substrate.

The packaging substrate may be mounted on a main board and electrically connected to the main board.

A description of the packaging substrate and the element is omitted as it overlaps with that described above.

Method of manufacturing packaging substrate

A method of manufacturing a packaging substrate according to yet another embodiment of the present disclosure includes an insulating layer formation process of forming an insulating layer on a glass core.

A description of the glass core is omitted as it overlaps with that described above.

A glass core having an electrically conductive layer formed on the upper surface thereof as needed may be provided.

The insulating layer may be prepared by laminating a film for forming an insulating layer on the glass core followed by curing, or by applying a composition for forming an insulating layer onto the glass core followed by curing.

The film for forming an insulating layer may include an epoxy resin and a filler. The film for forming an insulating layer may include a curable epoxy resin and a filler.

The film for forming an insulating layer may include 10 wt% or more of the epoxy resin. The film for forming an insulating layer may include 15 wt% or more of the epoxy resin. The film for forming an insulating layer may include 20 wt% or more of the epoxy resin. The film for forming an insulating layer may include 35 wt% or less of the epoxy resin. The film for forming an insulating layer may include 32 wt% or less of the epoxy resin. The film for forming an insulating layer may include 29 wt% or less of the epoxy resin. The film for forming an insulating layer may include 25 wt% or less of the epoxy resin.

A description of the epoxy resin and the filler is omitted as it overlaps with that described above.

The film for forming an insulating layer may further include an additive commonly used in the field of build-up films. Examples of the additive include a stiffener, a colorant, an antifoaming agent, and the like.

An insulating layer may be formed by curing the film for forming an insulating layer laminated on the glass core. At least a portion of the film for forming an insulating layer may be disposed in contact with the upper surface of the glass core. At least a portion of the film for forming an insulating layer may be disposed in contact with the upper surface of the electrically conductive layer disposed on the glass core.

Curing may be performed by two or more processes, including a lamination process and a curing process.

In the lamination process, an exhaust atmosphere is formed, the film for forming an insulating layer is disposed on an area where an insulating layer is to be formed, and then pressure is applied to the film to laminate the same.

In the lamination process, the vacuum pressure may be 2 hPa or more. The vacuum pressure may be 3 hPa or more. The vacuum pressure may be 10 hPa or less.

The atmosphere temperature during the lamination process may be 50°C or more. The atmosphere temperature may be 60°C or more. The atmosphere temperature may be 100°C or less. The atmosphere temperature may be 90°C or less.

The pressure applied when laminating the film for forming an insulating layer may be 0.2 MPa or more. The pressure may be 0.3 MPa or more. The pressure may be 1 MPa or less.

The time for applying pressure during lamination of the film for forming an insulating layer may be 10 seconds or more. The time therefor may be 20 seconds or more. The time therefor may be 90 seconds or less. During the lamination process, the laminated film for forming an insulating layer may be additionally pressed.

When the laminated film for forming an insulating layer is pressed, the pressure applied may be 0.2 MPa or more. The pressure may be 0.3 MPa or more. The pressure may be 1 MPa or less.

The time for applying pressure during lamination of the film for forming an insulating layer may be 10 seconds or more. The time therefor may be 20 seconds or more. The time therefor may be 90 seconds or less.

The insulating layer may be formed by curing the laminated film for forming an insulating layer during the curing process. Curing process may include two or more curing stages

The atmosphere temperature during a first curing stage may be 85°C or more. The atmosphere temperature may be 90°C or more. The atmosphere temperature may be 95°C or more. The atmosphere temperature may be 150°C or less.

The atmosphere temperature during a second curing stage may be 120°C or more. The atmosphere temperature may be 140°C or more. The atmosphere temperature may be 160°C or more. The atmosphere temperature may be 250°C or less.

The first curing stage may be performed for 10 minutes or more. The first curing stage may be performed for 15 minutes or more. The first curing stage may be performed for 20 minutes or more. The first curing stage may be performed for 60 minutes or less.

The second curing stage may be performed for 1 minute or more. The second curing stage may be performed for 3 minutes or more. The second curing stage may be performed for 20 minutes or less.

As necessary, after forming an electrically conductive layer on the formed insulating layer, another insulating layer may be formed on the electrically conductive layer to surround the electrically conductive layer, forming a first redistribution layer.

A description of the electrically conductive layer and the first redistribution layer is omitted as it overlaps with that described above.

The electrically conductive layer may be formed by a dry or wet method.

The dry method is performed in a manner in which a seed layer is formed by sputtering in the area where the electrically conductive layer is to be disposed, and the area where the seed layer is formed is plated, thereby forming an electrically conductive layer. When forming the seed layer, metals such as titanium, chromium, nickel, etc. may be sputtered, and copper may be sputtered along with the metals. Sputtering may induce an anchoring effect in which metal particles interact with the surface of the glass core or insulating layer, improving adhesion of the electrically conductive layer.

The wet method is performed in a manner in which the area where an electrically conductive layer needs to be formed is treated with a primer followed by metal plating. The primer may include a compound having a functional group such as an amine, etc. Depending on the extent of adhesion intended, the primer may include a compound having a functional group such as an amine, etc. and a silane coupling agent. When applying a silane coupling agent, a primer layer may be formed by pretreating the surface to be primed with a silane coupling agent and then applying a compound having an amine group onto the pretreated area.

After forming the seed layer or the primer layer, metal plating may be performed to form an electrically conductive layer. Copper plating may be applied when forming the electrically conductive layer, but the present disclosure is not limited thereto. Before metal plating, the portion of the seed layer or primer layer that does not require formation of an electrically conductive layer may be deactivated, or the portion that requires formation of an electrically conductive layer may be activated. Activation or deactivation treatment methods may include light irradiation treatment using a laser at a specific wavelength, chemical treatment, etc. However, after metal plating is performed without activation or deactivation treatment, the electrically conductive layer may be patterned by etching according to a pre-designed shape.

After formation of the electrically conductive layer, an insulating layer surrounding the electrically conductive layer may be formed. The insulating layer disposed on the electrically conductive layer may be formed using the same method as described above.

As necessary, a second redistribution layer may be formed using the method applied to forming the first redistribution layer under the glass core.

The method of manufacturing a packaging substrate according to the present disclosure may further include a process of forming a connection terminal, a bump, a cover layer, etc. on the upper surface and/or lower surface of the packaging substrate, or mounting an element on the substrate.

A better understanding of the present disclosure may be obtained through the following examples. These examples are merely set forth to illustrate the present disclosure and are not to be construed as limiting the scope of the present disclosure.

**Manufacture Example: Manufacture of packaging substrate**

Example 1: CELLFIL MD200, a build-up film from Taiyo Corporation, was laminated on a glass substrate having a thickness of 400 $\mu$m. The build-up film contained 78 wt% of silica, the average particle size of the silica was controlled to 1.5 $\mu$m, and the maximum particle size of the silica was controlled to 8 $\mu$m.

After completing the first curing stage by heat-treating the substrate on which the build-up film was laminated at 100°C for 30 minutes, the substrate was heat-treated at 180°C for 5 minutes to complete the second curing stage, thereby providing an insulating layer.

In the same way, seven insulating layers were further formed on the insulating layer, and a total of eight insulating layers was formed under the glass substrate. The thickness of the insulating layer formed on the glass core and the thickness of the insulating layer formed under the glass core were both measured to be 260 $\mu$m.

Thereafter, a packaging substrate was prepared by dicing the glass substrate with insulating layers formed thereon and thereunder.

Comparative Example 1: A packaging substrate was prepared under the same conditions as Example 1, with the exception that New LE from Ajinomoto Co., Ltd. was used as the build-up film.

Comparative Example 2: A packaging substrate was prepared under the same conditions as Example 1, with the exception that New 2 from Ajinomoto Co., Ltd. was used as the build-up film.

Comparative Example 3: A packaging substrate was prepared under the same conditions as Example 1, with the exception that GX31 from Ajinomoto Co., Ltd. was used as the build-up film.

Comparative Example 4: A packaging substrate was prepared under the same conditions as Example 1, with the exception that GXT62 from Ajinomoto Co., Ltd. was used as the build-up film.

**Evaluation Example: Measurement of properties of insulating layer**

The insulating layer was cut in the packaging substrate of each of Example and Comparative Examples and used as a test specimen. The elastic modulus, tensile strength, and elongation of the insulating layer of each of Example and Comparative Examples were measured using a universal testing machine. The atmosphere temperature was set to 23°C when measuring the elastic modulus, tensile strength, and elongation.

The glass transition temperature of the insulating layer was measured in the range of 20°C to 150°C for each of Examples and Comparative Examples using a differential scanning calorimeter. In addition, the coefficient of thermal expansion at 23°C of the insulating layer of each of Examples and Comparative Examples was measured using a dynamic mechanical analysis method.

In addition, a test specimen was prepared by cutting the insulating layer of each of Example and Comparative Examples to 30 mm in width, 30 mm in length, and 50 μm in thickness. The test specimen was dried at 130°C for 30 minutes and then the mass thereof was measured. Thereafter, the test specimen was immersed in boiled deionized water for 1 hour, then taken out, and then immersed in deionized water at room temperature for 1 minute, then taken out. Thereafter, the moisture on the surface of the test specimen was removed and then the mass of the test specimen was measured. The change in mass of the test specimen before and after immersion compared to the mass of the test specimen before immersion was calculated as the boiling water absorption rate.

Also, the dielectric constant and loss tangent of the insulating layers of Example 1 and Comparative Example 3 were measured at room temperature using a dielectric constant meter.

The measured values of the insulating layer of each of Examples and Comparative Examples and the HEI of the below Equation 1 and HMI of the below Equation 2 calculated from the measured values are shown in Tables 1 and 2 below.

**Evaluation Example: Assessing whether SeWaRe phenomenon occurs**

In the packaging substrate of each of Examples and Comparative Examples, whether the SeWaRe phenomenon, in which the glass core splits vertically, occurred was visually observed.

Thereby, if no defect was found, it was evaluated as Pass, and if a defect was found, it was evaluated as Fail.

The evaluation results for each of Example and Comparative Examples are shown in Table 2 below.

[Equation 1]

$$HEI = \frac{Tg}{E \times CTE}$$

in Equation 1, Tg is a glass transition temperature (unit: °C), E is an elastic modulus (unit: GPa) measured at 23°C, and CTE is a coefficient of thermal expansion (ppm/°C).

[Equation 2]

$$HMI = \frac{10 \times Tg \times Eln}{(10E + T) \times CTE}$$

in Equation 2,

Tg is a glass transition temperature (unit: °C), CTE is a coefficient of thermal expansion (ppm/°C), E is an elastic modulus (unit: GPa) of the insulating layer measured at 23°C, T is a tensile strength (unit: MPa) of the insulating layer measured at 23°C, and Eln is an elongation (%) of the insulating layer measured at 23°C.

[Table 1]

| | HEI | HMI | Glass transition temperature (°C) | Coefficient of thermal expansion (ppm/°C) | Elastic modulus (GPa) | Tensile strength (MPa) | Elongation (%) |
|---|---|---|---|---|---|---|---|
| Example 1 | 1.83 | 1.90 | 172.5 | 14 | 6.75 | 62.5 | 2 |
| Comparative Example 1 | 1.09 | 0.65 | 152 | 14 | 10 | 84 | 1.1 |
| Comparative Example 2 | 0.72 | 0.80 | 152 | 15 | 14 | 112 | 2 |
| Comparative Example 3 | 0.89 | 0.90 | 154 | 23 | 7.5 | 104 | 2.4 |
| Comparative Example 4 | 0.56 | 1.14 | 156 | 37 | 7.5 | 125 | 5.4 |

**EP 4 672 317 A1**

[Table 2]

|  | Boiling water absorption rate (wt%) | Dielectric constant | Loss tangent | Assessing whether SeWaRe phenomenon occurs |
|---|---|---|---|---|
| Example 1 | Less than 1 | 3.5 | 0.014 | Pass |
| Comparative Example 1 | 0.4 | - | - | Fail |
| Comparative Example 2 | 0.2 | - | - | Fail |
| Comparative Example 3 | 0.6 | 3.1 | 0.013 | Fail |
| Comparative Example 4 | - | - | - | Fail |

Referring to Table 2, in Example 1, no damage to the glass core occurred, but the SeWaRe phenomenon occurred in all of Comparative Examples 1 to 4.

Although the preferred embodiments of the present invention have been described in detail above, the scope of the present invention is not limited thereto, and various modifications and improvements made by those skilled in the art using the basic concept of the present invention defined in the following claims also fall within the scope of the present invention.

**Claims**

1. A packaging substrate comprising a glass core and an insulating layer disposed on the glass core,

   wherein the glass core has a thickness of 100 μm or more, and
   the insulating layer has an HEI value, which is a heat-resistant elasticity index of Equation 1 below, of 1.2 or more:

   [Equation 1]

   $$HEI = \frac{Tg}{E \times CTE}$$

   in Equation 1,
   Tg is a glass transition temperature (unit: °C), E is an elastic modulus (unit: GPa) measured at 23°C, and CTE is a coefficient of thermal expansion (ppm/°C).

2. The packaging substrate of claim 1,
   wherein the insulating layer has an HMI value, which is a heat-resistant mechanical property index of Equation 2 below, of 1.4 or more:

   [Equation 2]

   $$HMI = \frac{10 \times Tg \times Eln}{(10E + T) \times CTE}$$

   in Equation 2,
   Tg is a glass transition temperature (unit: °C), CTE is a coefficient of thermal expansion (ppm/°C), E is an elastic modulus (unit: GPa) of the insulating layer measured at 23°C, T is a tensile strength (unit: MPa) of the insulating layer measured at 23°C, and Eln is an elongation (%) of the insulating layer measured at 23°C.

3. The packaging substrate of claim 1,
   wherein an elastic modulus of the insulating layer measured at 23°C is 8 GPa or less.

4. The packaging substrate of claim 1,
   wherein a coefficient of thermal expansion of the insulating layer is 25 ppm/°C or less.

**5.** The packaging substrate of claim 1,
wherein a glass transition temperature of the insulating layer is 160°C or more.

**6.** The packaging substrate of claim 1,
wherein a tensile strength of the insulating layer measured at 23°C is 80 MPa or less.

**7.** The packaging substrate of claim 1,

comprising a first redistribution layer disposed on the glass core,
wherein the first redistribution layer comprises an electrically conductive layer and the insulating layer surrounding at least a portion of the electrically conductive layer, and
a ratio of a thickness of the first redistribution layer relative to the thickness of the glass core is 0.3 or more.

**8.** The packaging substrate of claim 7,

further comprising a second redistribution layer disposed under the glass core,
wherein the second redistribution layer comprises the electrically conductive layer and the insulating layer surrounding at least a portion of the electrically conductive layer, and
a ratio of a sum of the thickness of the first redistribution layer and a thickness of the second redistribution layer relative to the thickness of the glass core is 0.5 or more.

**9.** The packaging substrate of claim 1, wherein the insulating layer comprises a curable resin and a filler, and
the insulating layer comprises at least 65 wt% of the filler.

**10.** The packaging substrate of claim 1,

comprising a first electrically conductive layer disposed in contact with an upper surface of the glass core,
wherein the insulating layer surrounds a portion of the first electrically conductive layer, and
a ratio of an area occupied by the first electrically conductive layer on the upper surface of the glass core relative to a total area of the upper surface of the glass core is 80% or less.

FIG. 1

101

21

11

After Repeated Thermal Process

Delamination

Crack

FIG. 2

100

20

10

FIG. 3

<u>100</u>

**EUROPEAN SEARCH REPORT**

Europäisches
Patentamt
European
Patent Office
Office européen
des brevets

Application Number

EP 25 16 5846

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 389 419 A1 (TOYO BOSEKI [JP]) 26 June 2024 (2024-06-26) | 1-8,10 | INV. H01L23/15 H01L23/498 |
| Y | * paragraphs [0004], [0014], [0016], [0033], [0043], [0045], [0051] - [0053], [0060], [0066], [0075] - [0076] * | 9 | |
| X | US 2003/219588 A1 (OGAWA MAKOTO [JP] ET AL) 27 November 2003 (2003-11-27) | 1-5,7,8, 10 | |
| Y | * paragraphs [0022], [0026], [0028] - [0029], [0031], [0035], [0037] - [0038], [0042] * * pages 1-5; figures 1-5 * | 9 | |
| Y | US 2009/267212 A1 (WADA MASAHIRO [JP] ET AL) 29 October 2009 (2009-10-29) * paragraph [0210] * | 9 | |
| Y | EP 3 028 851 A1 (HITACHI CHEMICAL CO LTD [JP]) 8 June 2016 (2016-06-08) * paragraphs [0034] - [0035] * | 9 | |

TECHNICAL FIELDS
SEARCHED (IPC)

H01L

The present search report has been drawn up for all claims

| Place of search | Date of completion of the search | Examiner |
|---|---|---|
| The Hague | 26 August 2025 | Rodríguez San S., H |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P4C01)

## ANNEX TO THE EUROPEAN SEARCH REPORT
## ON EUROPEAN PATENT APPLICATION NO.

EP 25 16 5846

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2025

| Patent document cited in search report | | | Publication date | Patent family member(s) | | Publication date |
|---|---|---|---|---|---|---|
| EP | 4389419 | A1 | 26-06-2024 | CN | 117813200 A | 02-04-2024 |
| | | | | EP | 4389419 A1 | 26-06-2024 |
| | | | | JP | WO2023021899 A1 | 23-02-2023 |
| | | | | KR | 20240046166 A | 08-04-2024 |
| | | | | TW | 202323379 A | 16-06-2023 |
| | | | | US | 2024375381 A1 | 14-11-2024 |
| | | | | WO | 2023021899 A1 | 23-02-2023 |
| US | 2003219588 | A1 | 27-11-2003 | JP | 2003298196 A | 17-10-2003 |
| | | | | US | 2003219588 A1 | 27-11-2003 |
| US | 2009267212 | A1 | 29-10-2009 | CA | 2630824 A1 | 20-03-2008 |
| | | | | CN | 101356643 A | 28-01-2009 |
| | | | | EP | 1956648 A1 | 13-08-2008 |
| | | | | JP | 4802246 B2 | 26-10-2011 |
| | | | | JP | 2010004050 A | 07-01-2010 |
| | | | | JP | WO2008032620 A1 | 21-01-2010 |
| | | | | KR | 20080091086 A | 09-10-2008 |
| | | | | KR | 20110000761 A | 05-01-2011 |
| | | | | SG | 160403 A1 | 29-04-2010 |
| | | | | TW | 200830486 A | 16-07-2008 |
| | | | | US | 2009267212 A1 | 29-10-2009 |
| | | | | WO | 2008032620 A1 | 20-03-2008 |
| EP | 3028851 | A1 | 08-06-2016 | CN | 103009721 A | 03-04-2013 |
| | | | | CN | 203093219 U | 31-07-2013 |
| | | | | EP | 2759400 A1 | 30-07-2014 |
| | | | | EP | 3028851 A1 | 08-06-2016 |
| | | | | JP | 6579464 B2 | 25-09-2019 |
| | | | | JP | 6801631 B2 | 16-12-2020 |
| | | | | JP | 2018069737 A | 10-05-2018 |
| | | | | JP | WO2013042748 A1 | 26-03-2015 |
| | | | | KR | 20140063710 A | 27-05-2014 |
| | | | | KR | 20190064661 A | 10-06-2019 |
| | | | | TW | 201328868 A | 16-07-2013 |
| | | | | TW | 201906726 A | 16-02-2019 |
| | | | | WO | 2013042748 A1 | 28-03-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63666118